Europäisches Patentamt

**European Patent Office**

Office européen des brevets

(11) Publication number: **0 058 279**
A2

# EUROPEAN PATENT APPLICATION

(21) Application number: **81305783.3**

(22) Date of filing: **08.12.81**

(51) Int. Cl.³: **G 11 C 11/34**
**G 11 C 5/00**

(30) Priority: **17.02.81 GB 8104904**

(43) Date of publication of application:
**25.08.82 Bulletin 82/34**

(84) Designated Contracting States:
**BE CH DE FR IT LI NL**

(71) Applicant: **Hughes Microelectronics Limited**
**Fullerton Road**
**Glenrothes Fife Scotland(GB)**

(72) Inventor: **Edwards, Colin Walter**
**Tree Tops Lincoln Road**
**Chalfont St. Peter Bucks(GB)**

(72) Inventor: **Murray, Kenelm Gerald Digby**
**3 Stringhams Copse**
**Sendmarsh Ripley Surrey(GB)**

(74) Representative: **Colgan, Stephen James et al,**
**CARPMAELS & RANSFORD 43 Bloomsbury Square**
**London WC1A 2RA.(GB)**

(54) **Non-volatile semiconductor memory circuits.**

(57) A non-volatile semiconductor memory circuit having at
least one variable threshold FATMOS transistor (Q3, Q4) in
the cross-coupled lateral branches and a plurality of input
switching transistors controlling operation of the circuit.
Capacitive imbalance between the nodes (X1, X2) of the
circuit between a node (X1) and an input switching transistor
(Q14) driven by the same control signal as a corresponding
transistor (Q13) connected between the other node (X2) and
an input switching transistor (Q15). This reduces the occurr-
ence of wrong-state switching in the circuit during reading.

FIG.3.

EP 0 058 279 A2

## NON-VOLATILE SEMICONDUCTOR MEMORY CIRCUITS

This invention relates to non-volatile semiconductor memory circuits.

Semiconductor memories can be classified as volatile (where stored information is lost upon power removal) and non-volatile (where stored information is maintained after power removal, and which can be accurately retrieved after subsequent power-up). Several types of non-volatile semi-conductor memories are known, notably based on MNOS transistors, FAMOS transistors, or FATMOS transistors. A description of prior MNOS and FAMOS memory circuits is given in U.S. Patent 4,132,904. The latter patent, together with U.K. Specification No.2,000,407 describe and claim FATMOS non-volatile latch memory circuits.

The FATMOS is basically a control gate plus floating gate MOS transistor with a portion of the floating gate lying close to the semiconductor substrate. When the source and drain connections are connected to an appropriate potential (one positive relative to the other) and a suitable potential of a first magnitude applied to the control gate, the transistor conducts. Upon removal of the control gate potential, conduction ceases. If a potential of a second and higher magnitude is applied to the control gate with the drain at zero voltage, the transistor again conducts, but in addition electric charges tunnel between the floating gate and the transistor substrate through the portion of the floating gate closest to the substrate. This charge remains on the floating gate even when the control gate potential is removed and increases the switching threshold of the device. This charge on the floating gate enables the transistor to be employed in a non-volatile memory, as described in U.K. Specification No. 2,000,407. The switching threshold of the FATMOS is returned to its original level by applying between the control gate and drain a potential of approximately the second and higher potential, but of opposite polarity.

In a typical example of an N-channel enhancement-type FATMOS, the area of the floating gate closest to the substrate overlies the drain of the transistor, although this is not essential and the area closest to the substrate can be elsewhere on the transistor. In normal, non-volatile operation of a latch including such a FATMOS device, a voltage of typically +5 to +7 volts is applied to the control gate of the FATMOS. To write non-volatile information into the latch, a voltage of typically +8 to +15 volts is applied to the control gate of the FATMOS. If power is removed from the latch and then subsequently restored, it settles into a logic state dictated by its state during the earlier non-volatile write operation.

Although FATMOS transistors work well when employed in non-volatile memory cells (see U.K. Specification No. 2,000,407) certain configurations of FATMOS transistors can sometimes be unpredictable during reading after the FATMOS's have been placed in their non-volatile written mode (higher threshold state). This unpredictability manifests itself by the FATMOS transistor(s) switching to the wrong state (i.e. a FATMOS with a charge retained on its floating gate being held "off" instead of "on" and vice-versa).

Wrong state switching during reading is particularly noticeable when the shift in the switching threshold of a FATMOS is low, as can occur towards the end of the life of a FATMOS or as a result of normal production variations. The low threshold shift increases the relative effect of other sources of imbalance in the memory cell which may override the effect of the threshold shift and cause the cell to go into the wrong state on reading.

The present invention is concerned with reducing the imbalance in a memory cell due to effects other than those produced by putting the FATMOS devices into their non-volatile modes, so as to improve the reliability of the cell when the threshold shifts are low.

According to the present invention there is provided a non-volatile semiconductor memory circuit having a pair of cross-coupled branches connectable across a common supply voltage, each branch including a complementary driver or load, a driver connected in series with the complementary driver or load at an output node and a plurality of input switching devices operable by input signals, at least one of said complementary drivers or loads, or drivers including an insulated gate field effect transistor (IGFET) having a threshold voltage which may be varied by raising its gate potential above a predetermined level relative to the potential on one of its electrodes so as to store data in the circuit, wherein a first transistor connected between the output node and an input switching device in one branch is arranged to be in the same state as a corresponding second transistor connected between the output node and an input switching device in the other branch when data stored in the circuit is being read out.

Non-voltaile semiconductor memory circuits constructed in accordance with the invention will now be described by way of example and with reference to the accompanying drawings in which:-

Figure 1 is an electrical circuit diagram of a first memory circuit; and

·Figures 2 and 3 are circuit diagrams of a second memory circuit.

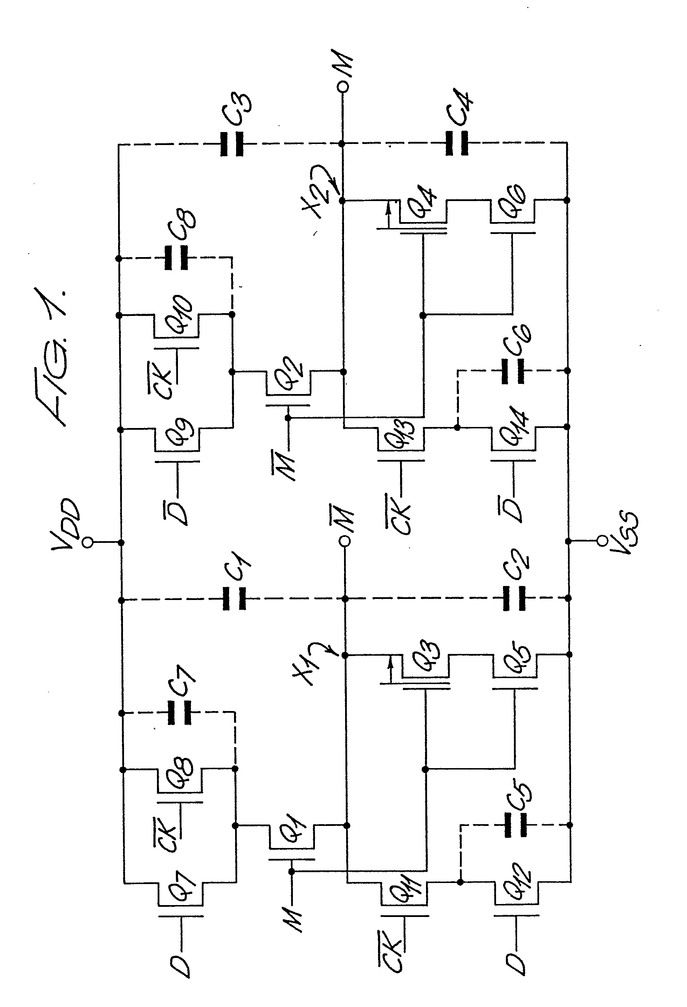

Referring to Figure 1, there is shown a CMOS non-voltaile flip-flop having P-channel complementary drivers (or loads) $Q_1$, $Q_2$, and N-channel drivers constituted by FATMOS devices $Q_3$, $Q_4$, and their series transistros $Q_5$, $Q_6$. The control gates of the transistors $Q_1$ to $Q_6$ are cross-coupled to the nodes of each opposite branch of the cell, such nodes being indicated as $X_1$ and $X_2$. The signal levels at these nodes set the output signals from the cell M and $\bar{M}$. Input data signals to the cell D, $\bar{D}$ and a clocking signal

$\overline{CK}$ control input switching transistors $Q_7$ to $Q_{14}$ to enable data to be written into the cell and read out when required. If the clocking signal $\overline{CK}$ is at its high level, the P-channel transistors $Q_8$, $Q_{10}$ will be "off" and the N-channel transistors $Q_{11}$, $Q_{13}$ will be "on", so that when the data signal D is "high, the P-channel transistor $Q_7$ is "off" and the N-channel transistor $Q_{12}$ is "on", which causes the node $X_1$ to drop to its logic "0" state, and conversely the signal $\overline{D}$ causes the P-channel transistor $Q_9$ to turn "on" and the N-channel transistor $Q_{14}$ to turn "off" allowing the node $X_2$ to go to its logic "1" state. In this way data is put into the cell from the input switching transistors when the clocking signal $\overline{CK}$ is high and can be held in a non-volatile written state by raising the electrode voltages on the FATMOS devices $Q_3$ and $Q_4$ with $\overline{CK}$ at its "low" level, in the manner described in the above mentioned UK Patent Specification No. 2,000,407.

When the clocking signal $\overline{CK}$ is at its "low" level the P-channel transistors $Q_8$ and $Q_{10}$ are "on" and the N-channel transistor $Q_{11}$ and $Q_{13}$ are "off", so that even if the value of the data signals D, $\overline{D}$ changes the flip-flop transistors $Q_1$ to $Q_6$ remain in the same state.

With the cell in its non-volatile written state one of the FATMOS devices will have a different charge stored on its floating gate than the other FATMOS device.

When voltage is then applied across the voltage rails $V_{DD}$, $V_{SS}$ this difference in charge gives the FATMOS transistors $Q_3$, $Q_4$ different threshold voltages and hence causes one of them to turn on before the other, tipping the flip-flop into the correct state corresponding to the data originally written into the cell.

This data is read out from the cell with the clocking signal $\overline{CK}$ at its "low" level.

However, during power-up, as the voltage rails $V_{DD}$, $V_{SS}$ move apart, any stray capacitance between either of the nodes $X_1$ or $X_2$ and one of the power rails will effect the voltages at the nodes. If the capacitance between node $X_1$ and one of the power rails is different from the capacitance between node $X_2$ and the same power rail then this will produce a voltage difference between the nodes during power-up which may be sufficient to override the difference in threshold voltages between the FATMOS transistors and cause the wrong one to turn on first, thus driving the flip-flop into the wrong state.

One source of stray capacitance in the circuit is the internal capacitance of the interconnections at each junction between transistors . These capacitances connect to the supply rails and combine in the circuit of Figure 1 to give the effective stray capacitors $C_1$-$C_8$. The size of these stray capacitors depend on the physical parameters of the various transistors and careful control of the design and production of the memory cell can ensure that $C_1$, $C_2$, $C_5$ and $C_7$ are substantially equal to $C_3$, $C_4$ $C_6$ and $C_8$ respectively. Thus the stray capacitors connected directly to the nodes $X_1$, $X_2$ can be balanced so that the capacitance at each node is the same. However, the capacitors $C_7$, $C_8$, $C_5$ and $C_6$ connect to the nodes via transistors $Q_1$, $Q_2$, $Q_{11}$ and $Q_{13}$ and the state of those transistors will therefore effect the capacitance at each node. In Figure 1 $Q_{11}$ and $Q_{13}$ are both driven by the clocking signal $\overline{CK}$ so that they are always in the same state. Thus the stray capacitances $C_5$ and $C_6$ across the transistors $Q_{12}$ and $Q_{14}$ which are respectively in series with $Q_{11}$ and $Q_{13}$ are either both connected to the respective nodes or both disconnected, and the balance of capacitance at the nodes is maintained. If the transistors $Q_{11}$ and $Q_{13}$ were driven by different signals, such as D and $\overline{D}$ ($Q_{12}$ and $Q_{14}$ being driven by $\overline{CK}$) then an imbalance in the capacitance at the nodes would be introduced which could cause wrong-state switching of the memory cell.

Since $Q_{11}$ and $Q_{13}$ are driven by $\overline{CK}$, they will be both "off" during the read operation, which further ensures that any slight differences between $C_5$ and $C_6$ due to production variations or other factors will not effect the balance between the nodes if the memory cell is switched on in its data reading state.

The stray capacitors $C_7$ and $C_8$ connect to the nodes $X_1$ $X_2$ through the complementary driver or load transistors of the flip-flop $Q_1$ and $Q_2$, and do not effect the operation of the memory cell during reading since the capacitors $C_7$ and $C_8$ are shorted out by $\overline{CK}$ turning $Q_8$ and $Q_{10}$ "on". It will, however, be noted that the transistors $Q_7$ $Q_8$ and $Q_9$ $Q_{10}$ are connected to the nodes $X_1$ $X_2$ through transistors $Q_1$ and $Q_2$ and that since during reading these transistors $Q_1$ and $Q_2$ are initially in the same state any stray capacitance at the gates of transistors $Q_7$ and $Q_9$ will not imbalance the cell. Thus a further source of imbalance is removed by this particular configuration of the transistors $Q_1$ $Q_2$ and $Q_7$ to $Q_{10}$.

The cell shown in Figure 1 has a CMOS configuration with FATMOS N-channel drivers. The converse configuration with FATMOS P-channel drivers is also possible.

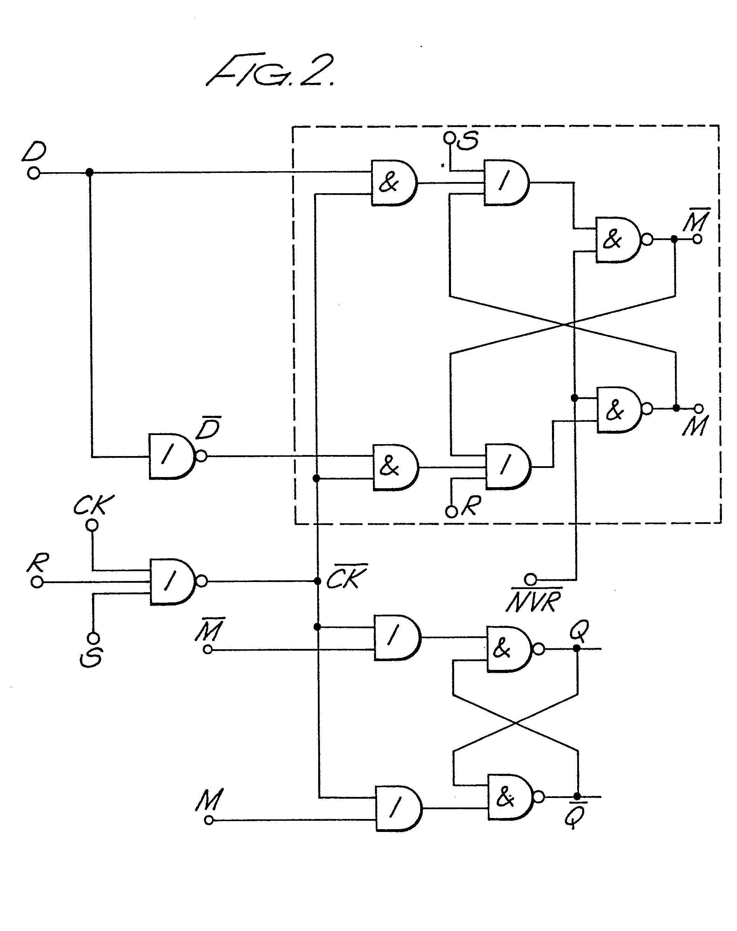

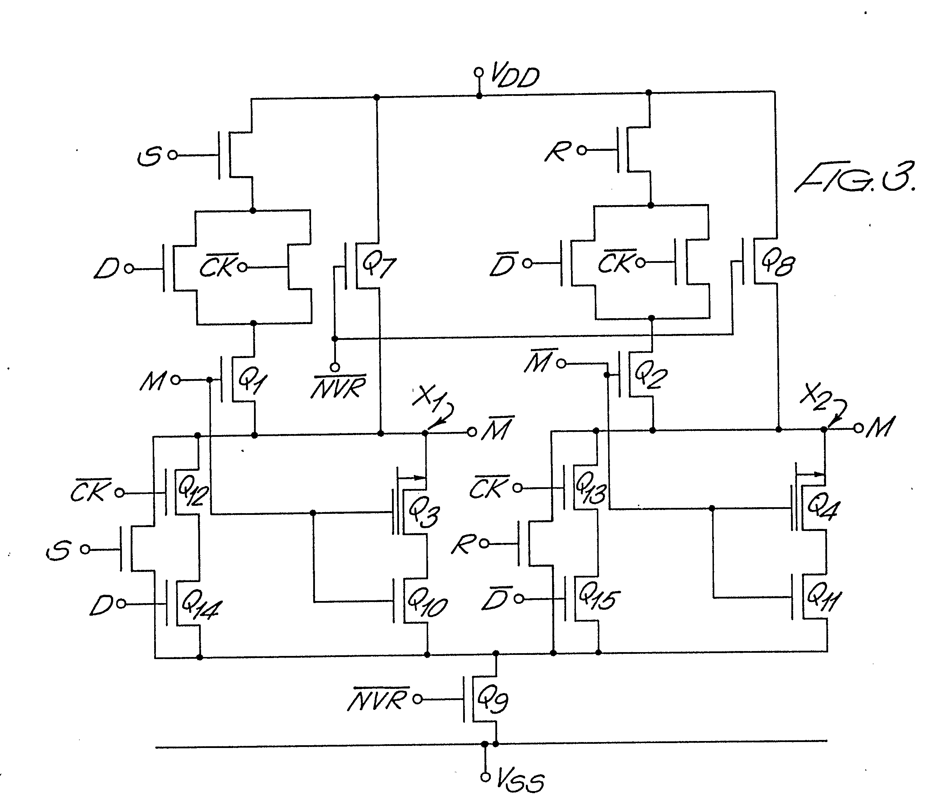

A second embodiment of the invention is illustrated in Figures 2 and 3, wherein a non-volatile read operation by means of an $\overline{NVR}$ signal is employed in a non-volatile D-type set-reset master-slave flip-flop. The logic circuit for the flip-flop is shown in Figure 2 with the usual symbols for the AND, OR, NAND and NOR gates, and with the D-input signal D, set signal S, reset signal R, and clock signal CK. The master flip-flop is shown within the dashed box, supplying outputs M, $\overline{M}$ to the slave flip-flop below the dashed box. The latter flip-flop has outputs Q, $\overline{Q}$.

Only the master flip-flop need be non-volatile and it receives the $\overline{NVR}$ signal for non-volatile reading as shown. The detailed circuit for the master flip-flop is shown in Figure 3, and although it is drawn slightly differently from the cell shown in Figure 1, it functions similarly thereto. It includes complementary drivers (or loads) $Q_1$, $Q_2$, FATMOS drivers $Q_3$, $Q_4$, and non-volatile read transistors $Q_7$ to $Q_9$. Transistors $Q_{10}$, $Q_{11}$ are provided in series with the FATMOS drivers $Q_3$, $Q_4$. The various input switching transistors to enable the flip-flop to function in a logically correct manner (e.g. with S or R signals) are also shown. During both reading and writing operations the clock input $\overline{CK}$ must be held low so that the data in the master flip-flop is transferred to the slave flip-flop.

To write non-volatile information into the D-type, the $\overline{CK}$ input is held low and $V_{DD}$ raised from its normal +5 volts to about +12 volts (typically for 50 µsec). This alters the thresholds of the FATMOS drivers $Q_3$, $Q_4$ as has been previously described in U.S. Patent No. 4,132,904 and U.K. Patent Specification No. 2,000,407. To read this information out of the D-type, the $\overline{NVR}$ signal is applied. This immediately turns on $Q_7$, $Q_8$: turns off $Q_9$, and causes both nodes $X_1$, $X_2$ to go positive. At this stage the FATMOS devices $Q_3$, $Q_4$ are on, but are isolated from the negative supply rail $V_{SS}$, and $Q_1$, $Q_2$ are held off. When the $\overline{NVR}$ signal is removed, $Q_7$, $Q_8$ commence to go off, $Q_9$, commences to go on, and the nodes $X_1$, $X_2$ start to descend towards the negative supply voltage. At this time, also, the FATMOS devices $Q_3$, $Q_4$ start to switch on, but due to their variable thresholds one turns on faster than the other and dictates the stable state into which the latch settles. In this manner, the FATMOS transistors have maximum effect during this unstable period. A further advantage of precharging the latch nodes positively at a non-volatile read operation by means of the $\overline{NVR}$ signal is that the non-volatile stored information can be recovered at any time independently of the power supply switch on. Not only is this more convenient, but also enables design constraints on the power supply to be reduced. Reading can occur repeatedly (to bring back the previously non-volatile written information) without requiring power switch-off each time. Typically the $\overline{NVR}$ signal is about 5 volts negative for a few microseconds. The master flip-flop settles into a stable state dictated by the previous non-volatile write operation and this, with the clock input $\overline{CK}$ held low, is transferred to the slave flip-flop and presented as outputs Q, $\overline{Q}$, It will be appreciated that the non-volatile read operation causes the master flip-flop to settle into a logic state opposite to that written in during non-volatile writing.

As in the circuit of Figure 1, the switching transistors $Q_{12}$ and $Q_{13}$ which are connected between the nodes $X_1$ $X_2$ and the switching transistors $Q_{14}$ $Q_{15}$ are both controlled by the same signal $\overline{CK}$ so that the stray capacitance across $Q_{14}$ and $Q_{15}$ does not imbalance the nodes during power-up.

Any indirect effect on the nodes by stray capacitance connecting through the transistors $Q_3$ and $Q_{10}$ or $Q_4$ and $Q_{11}$ is prevented from causing imbalance by ensuring that $Q_{10}$ and $Q_{15}$ are connected in common to a single transistor $Q_9$ which connects them to the negative supply line $V_{SS}$.

In the circuits of both Figure 1 and Figure 3 the P-type transistors have their substrates connected to $V_{DD}$ and the N-type transistors have their substrates connected to $V_{SS}$, as is conventional practice in such circuits.

This balancing of the capacitive loading at the nodes is not necessarily restricted to D-type circuits but is of general application in the design of non-volatile memory elements, in particular RAM cells.

Claims:

1. A non-volatile semiconductor memory circuit having a pair of cross-coupled branches connectable across a common supply voltage, each branch including a complementary driver or load, a driver connected in series with the complementary driver or load at an output node and a plurality of input switching devices operable by input signals, at least one of said complementary drivers or loads, or drivers including an insulated gate field effect transistor (IGFET) having a threshold voltage which may be varied by raising its gate potential above a predetermined level relative to the potential on one of its electrodes so as to store data in the circuit, wherein a first transistor connected between the output node and an input switching device in one branch is arranged to be in the same state as a corresponding second transistor connected between the output node and an input switching device in the other branch when data stored in the circuit is being read out.

2. A circuit as claimed in claim 1, wherein each branch has a first input gating arrangement which is connected to the respective one of the output nodes in parallel with the driver and has a plurality of the input switching devices, and wherein the first and second transistors are input switching devices in the first input gating arrangement.

3. A circuit as claimed in claim 2, wherein the first and second transistors are operated by a clocking signal which controls the transfer of data into the memory and the input switching devices connected to the said first and second transistors are operated by data signals.

4. A circuit as claimed in claim 2 or 3, wherein each branch has a second input gating arrangement having a plurality of the input switching devices operable by the same input signals as the first input gating arrangement and connected in series with the complementary driver or load between the complementary driver or load and a connection to the supply voltage.

5. A circuit as claimed in any preceding claim, wherein the input switching devices are MOS transistors.

6. A circuit as claimed in any preceding claim, wherein one or both of said drivers include a variable threshold IGFET.

7. A circuit as claimed in any preceding claim, including means for precharging both output nodes to an identical logic state.

8. A circuit as claimed in claim 7, wherein the precharging means includes an MOS transistor in series with both drivers between the drivers and a connection to the supply voltage.

FIG. 1.

2/3

FIG.2.

FIG.3.